(19) Europäisches Patentamt
European Patent Office
Office européen des brevets

(11) **EP 2 583 110 B1**

(12) **FASCICULE DE BREVET EUROPEEN**

(45) Date de publication et mention
de la délivrance du brevet:
**02.07.2014 Bulletin 2014/27**

(21) Numéro de dépôt: **11724678.5**

(22) Date de dépôt: **15.06.2011**

(51) Int Cl.:
***G01R 31/12*** *(2006.01)*

(86) Numéro de dépôt international:
**PCT/EP2011/059947**

(87) Numéro de publication internationale:
**WO 2011/157753 (22.12.2011 Gazette 2011/51)**

(54) **PROCEDE DE LOCALISATION DE ZONE D'EMISSION DE DECHARGE PARTIELLE ET DISPOSITIF ASSOCIE**

VERFAHREN ZUR ORTUNG EINES TEILENTLADUNGS-ÜBERTRAGUNGSBEREICHS UND ZUGEHÖRIGE VORRICHTUNG

METHOD FOR LOCATING A PARTIAL DISCHARGE TRANSMISSION AREA AND ASSOCIATED DEVICE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **16.06.2010 FR 1054772**

(43) Date de publication de la demande:
**24.04.2013 Bulletin 2013/17**

(73) Titulaire: **Alstom Technology Ltd.**
**5400 Baden (CH)**

(72) Inventeurs:
• **LUNA, Gilbert**
**F-93420 Villepinte (FR)**
• **LOUISE, Sébastien**
**94600 CHOISY (FR)**

(74) Mandataire: **Ilgart, Jean-Christophe et al**
**BREVALEX**
**95, rue d'Amsterdam**
**75378 Paris Cedex 8 (FR)**

(56) Documents cités:
**EP-A1- 0 955 550**

• **PORTUGUES I E ET AL: "RF-Based Partial Discharge Early Warning System for Air-Insulated Substations", IEEE TRANSACTIONS ON POWER DELIVERY, IEEE SERVICE CENTER, NEW YORK, NY, US, vol. 24, no. 1, 1 janvier 2009 (2009-01-01), pages 20-29, XP011241001, ISSN: 0885-8977, DOI: DOI:10.1109/TPWRD. 2008.2005464**
• **GLOVER I A ET AL: "Radiometric Location of Partial Discharge Sources on Energized High-Voltage Plant", IEEE TRANSACTIONS ON POWER DELIVERY, IEEE SERVICE CENTER, NEW YORK, NY, US, vol. 20, no. 3, 1 juillet 2005 (2005-07-01), pages 2264-2272, XP011135362, ISSN: 0885-8977, DOI: DOI:10.1109/TPWRD. 2004.843397**
• **STEWART B G ET AL: "Triangulation and 3D location estimation of RFI and Partial Discharge sources within a 400kV substation", ELECTRICAL INSULATION CONFERENCE, 2009. EIC 2009. IEEE, IEEE, PISCATAWAY, NJ, USA, 31 mai 2009 (2009-05-31), pages 164-168, XP031491077, ISBN: 978-1-4244-3915-7**

**Description**

Domaine technique et art antérieur

L'invention concerne un procédé de localisation de zone d'émission de décharge partielle et un dispositif de localisation apte à mettre en oeuvre le procédé.

Des mesures de décharges partielles sont effectuées, en usine, sur les transformateurs de puissance afin de s'assurer de leur bon fonctionnement. Selon les conditions d'environnement, il peut arriver que les mesures de décharges partielles soient fortement perturbées par la présence de décharges parasites qui proviennent de sources électriques extérieures aux transformateurs. Le problème se pose alors de localiser ces décharges parasites afin de pouvoir les éliminer.

Diverses techniques sont connues de l'art antérieur pour localiser des décharges extérieures.

Un première technique connue est la localisation à l'aide d'un détecteur ultrasonique. Un premier problème rencontré par l'utilisation d'un détecteur ultrasonique est sa sensibilité à des perturbations autres que celles dues à des décharges. Un deuxième problème est la durée importante que peut prendre une localisation de source de décharges partielles lorsque le local dans lequel se situe la source est grand.

Une deuxième technique connue utilise une caméra ultra violet. Un premier problème rencontré par l'utilisation d'une caméra ultra-violet est qu'il n'est possible de localiser que des décharges qui ionisent l'air (décharges corona). Un autre inconvénient de cette technique est son coût très élévé.

Pour les deux techniques d'art antérieur mentionnées ci-dessus, il est par ailleurs nécessaire que l'activité des décharges soit continue et non sporadique car, sinon, la détection des décharges est très fortement aléatoire. Ceci représente également un autre inconvénient.

Le procédé de l'invention ne présente pas les inconvénients mentionnés ci-dessus.

Le procédé de l'invention utilise des détecteurs VHF et/ou UHF. Des procédés et dispositifs similaires sont divulgués dans PORTUGUES I E ET AL: "RF-Based Partial Discharge Early Waming System for Air-Insulated Substations", IEEE TRANSACTIONS ON POWER DELIVERY, IEEE SERVICE CENTER, NEW YORK, NY, US, vol. 24, no. 1, 1 janvier 2009 (2009-01-01), pages 20-29, XP011241001, dans GLOVER I A ET AL: "Radiometric Location of Partial Discharge Sources on Energized High-Voltage Plant", IEEE TRANSACTIONS ON POWER DELIVERY, IEEE SERVICE CENTER, NEW YORK, NY, US, vol. 20, no. 3, 1 juillet 2005 (2005-07-01), pages 2264-2272, XP011135362, dans EP 0 955 550 A1 et dans STEWART B G ET AL: "Triangulation and 3D location estimation of RFI and Partial Discharge sources within a 400kV substation", ELECTRICAL INSULATION CONFERENCE, 2009. EIC 2009. IEEE, IEEE, PISCATAWAY, NJ, USA, 31 mai 2009 (2009-05-31), pages 164-168, XP031491077. Le premier document divulgue toutes les caractéristiques techniques définies dans les préambules des revendications 1 et 4.

Exposé de l'invention

L'invention concerne un procédé de localisation d'une zone d'émission de décharge partielle selon la revendication 1 et un dispositif correspondant selon la revendication 4.

Selon un perfectionnement de l'invention, le dispositif de localisation de l'invention comprend deux chaînes de mesure supplémentaires sensiblement identiques aux quatre chaînes de mesure, les deux détecteurs supplémentaires D5 et D6 des deux chaînes de mesure supplémentaires étant positionnés dans un plan parallèle au plan (X, Y), à la verticale des détecteurs respectifs D1 et D2. Il est alors possible de déterminer une zone d'émission de décharge supplémentaire à l'aide des quatre détecteurs D1, D2, D5 et D6, dans un plan (Y, V), les axes X, Y, V définissant un trièdre direct [X, Y, V].

Ainsi, lorsque des zones d'émission de décharge partielle planes sont simultanémment localisées dans les plans respectifs (X, Y) et (Y, V), le procédé de l'invention permet-il de déterminer s'il existe une zone d'émission de décharge partielle sous la forme d'un volume dont les projections sur les plans (X, Y) et (Y, V) sont les zones d'émission planes déterminées.

Brève description des dessins

D'autres caractéristiques et avantages de l'invention apparaîtront à la lumière de la description qui va suivre, faite en référence aux figures jointes, parmi lesquelles :

- La figure 1 représente un dispositif apte à mettre en oeuvre une étape préliminaire de calibration nécessaire à la mise en oeuvre du procédé de l'invention;
- La figure 2 représente un exemple de dispositif pour la mise en oeuvre du procédé de l'invention ;
- Les figures 3A-3D représentent des signaux de mesure délivrés par les détecteurs UHF du dispositif représenté en figure 2 ;

- La figure 4 représente un perfectionnement du dispositif représenté en figure 2.

Sur toutes les figures, les mêmes références désignent les mêmes éléments.

Exposé détaillé d'un mode de réalisation préférentiel de l'invention

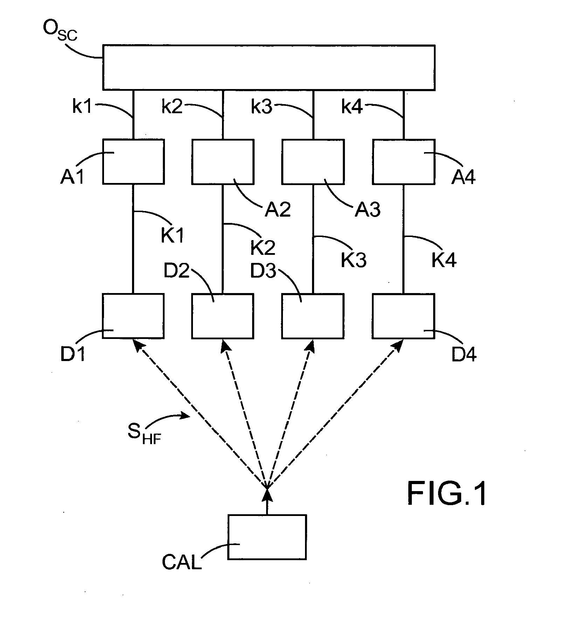

La figure 1 représente un dispositif apte à mettre en oeuvre une étape préliminaire de calibration nécessaire à la mise en oeuvre du procédé de l'invention.

Comme cela apparaîtra ci-dessous à la lecture du mode de réalisation préférentiel de l'invention, quatre chaînes de mesure sont utilisées pour la mise en oeuvre du procédé de l'invention. Chaque chaîne de mesure est constituée, par exemple, par un détecteur haute fréquence $D_i$ (par exemple un détecteur UHF), un câble coaxial long $K_i$, un amplificateur Ai et un câble coaxial court $k_i$. Le câble coaxial long $K_i$ a, par exemple, une longueur comprise entre 5m et 50m et le câble coaxial court, par exemple une longeur sensiblement égale à 1m. D'autres configurations de câblage entre le détecteur $D_i$ et l'amplificateur $A_i$ sont également possibles, les configurations de câblage ne dépendant que de raisons de commodité. Le détecteur haute fréquence travaille, par exemple, dans la bande de fréquences UHF 300MHz-1000MHz. Le détecteur haute fréquence peut également travailler dans une bande de fréquences VHF/UHF, par exemple la bande 200MHz-1000MHz. Les détecteurs VHF/UHF choisis sont de type omnidirectionnel afin de pouvoir détecter des décharges dans toutes les directions.

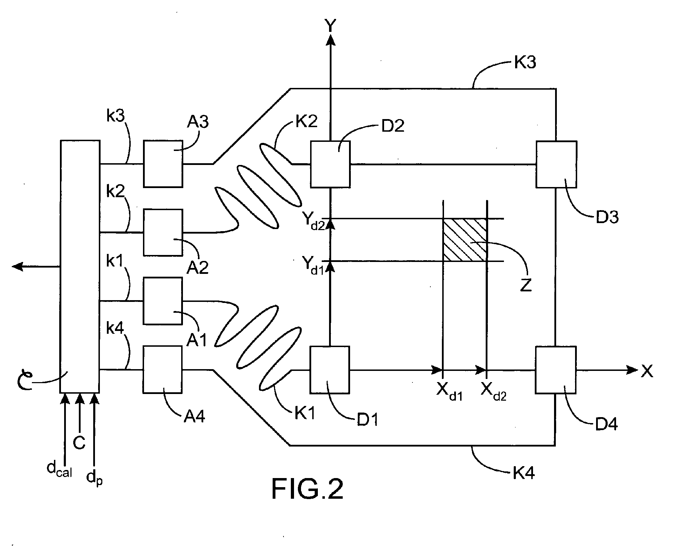

Les détecteurs Di et les amplificateurs Ai des différentes chaînes de mesure sont choisis identiques d'une chaîne de mesure à l'autre. De même, les longueurs des différents câbles sont choisies identiques d'une chaîne de mesure à l'autre. L'étape de calibration consiste à envoyer un signal haute fréquence $S_{HF}$ sur les quatre détecteurs UHF à partir d'un calibrateur à impulsion CAL (émission d'un signal dont le front de montée de quelques picosecondes excite des ondes dans la bande fréquences 200MHz-1000MHz). Un oscilloscope $O_{sc}$ mesure alors le signal électrique reçu en fonction du temps en bout de chaque chaîne de mesure. L'oscilloscope est déclenché sur l'un des quatre signaux détectés et les différences de temps entre les différents signaux sont mesurées. Les chaînes de mesure sont ajustées (longueurs des câbles, amplification) jusqu'à temps que les différences de temps mesurées ne dépassent pas une valeur de seuil égale, par exemple, à 5 nanosecondes. Les écarts de temps mesurés qui sont inférieurs à la valeur de seuil sont mémorisés pour être intégrés ultérieurement dans les calculs (cf. les données $d_{cal}$ en référence à la figure 2).

La figure 2 représente un dispositif qui met en oeuvre le procédé de l'invention. Les quatre détecteurs haute fréquence D1-D4 délimitent une surface carrée ou rectangulaire à l'intérieur de laquelle une source présumée de décharges partielles est à localiser. Les chaînes de mesure $D_i$, $K_i$, $A_i$, $k_i$ (i=1, 2, 3, 4) sont toutes reliées à un calculateur C ou, comme c'est le cas dans l'étape préliminaire de calibration, à un oscilloscope. Dans la suite de la description, on fera exclusivement référence au cas où les chaînes de mesure sont reliées à un calculateur. Le calculateur C reçoit comme signaux d'entrée les signaux délivrés par les quatre chaînes de mesure. Il reçoit également, en tant que paramètres de calcul, les données de calibration $d_{cal}$ précédemment mesurées et des données de position $d_p$ qui représentent les positions connues des quatre détecteurs D1-D4 dans un repère plan (X,Y) où, par exemple, le détecteur D1 est placé au point (0,0), le détecteur D2 au point (0, $Y_2$), le détecteur D3 au point ($X_3$, $Y_3=Y_2$) et le détecteur D4 au point ($X_4=X_3$, 0).

Dès lors qu'une décharge partielle survient dans la zone délimitée par les quatre détecteurs, les signaux mesurés par les quatre chaînes de mesure sont transmis au calculateur C. Le calculateur C détermine alors quatre différences de temps corrigées des données de calibration $d_{cal}$, à savoir :

- $TOA_{D2}-TOA_{D3}$ : différence entre les instants de réception des signaux détectés par les chaînes de mesure associées aux détecteurs respectifs D2 et D3 ;
- $TOA_{D4}-TOA_{D1}$ : différence entre les instants de réception des signaux détectés par les chaînes de mesure associées aux détecteurs respectifs D4 et D1;
- $TOA_{D1}-TOA_{D2}$ : différence entre les instants de réception des signaux détectés par les chaînes de mesure associées aux détecteurs respectifs D1 et D2 ;
- $TOA_{D3}-TOA_{D4}$ : différence entre les instants de réception des signaux détectés par les chaînes de mesure associées aux détecteurs respectifs D3 et D4.

La zone Z à partir de laquelle sont émises les décharges partielles est alors délimitée par les droites horizontales $X_{d1}$ et $X_{d2}$ et les droites verticales $Y_{d1}$ et $Y_{d2}$, définies, dans le repère (X, Y), par les équations ci-dessous:

$$X_{d1} = (X_3 / 2) + ((TOA_{D2} - TOA_{D3})/2) \times c$$

$$X_{d2} = (X_3 /2) - ((TOA_{D4} - TOA_{D1})/2) \times c$$

$$Y_{d1} = (Y_2 /2) + ((TOA_{D1} - TOA_{D2})/2) \times c$$

$$Y_{d2} = (Y_2 /2) - ((TOA_{D3} - TOA_{D4})/2) \times c$$

Où c est la vitesse de la lumière dans l'air libre ($310^8$m/s).

Dans le mode de réalisation préférentiel de l'invention, le calculateur C comprend un dispositif d'affichage qui affiche sur un écran la zone Z définie par les quatre droites $X_{d1}$, $X_{d2}$, $Y_{d1}$ et $Y_{d2}$.

Dans le cas où la source de décharges partielles est située sensiblement au centre du rectangle ou du carré défini par la position des quatre détecteurs UHF, la zone Z est une zone sensiblement ponctuelle située sensiblement au centre du rectangle. Dans le cas où la source de décharges partielles n'est pas au centre du rectangle, la zone Z est une surface plus ou moins étendue qui n'est pas centrée dans le rectangle.

De façon avantageuse, dans le cas d'une recherche de décharges partielles dans un hangar de grandes dimensions (typiquement 30m x 30m) où les détecteurs UHF sont placés aux quatre coins du hangar, la zone Z ne dépasse pas, de façon générale, quelques mètres de côté. Il est alors généralement facile de repérer visuellement la position exacte de la source de décharges partielles dans la zone Z déterminée. Dans le cas où le repérage visuel n'est pas possible, la zone Z étant faiblement étendue, l'utilisation d'un détecteur ultrasonore orienté vers la zone Z permet également un repérage rapide de la source de décharges.

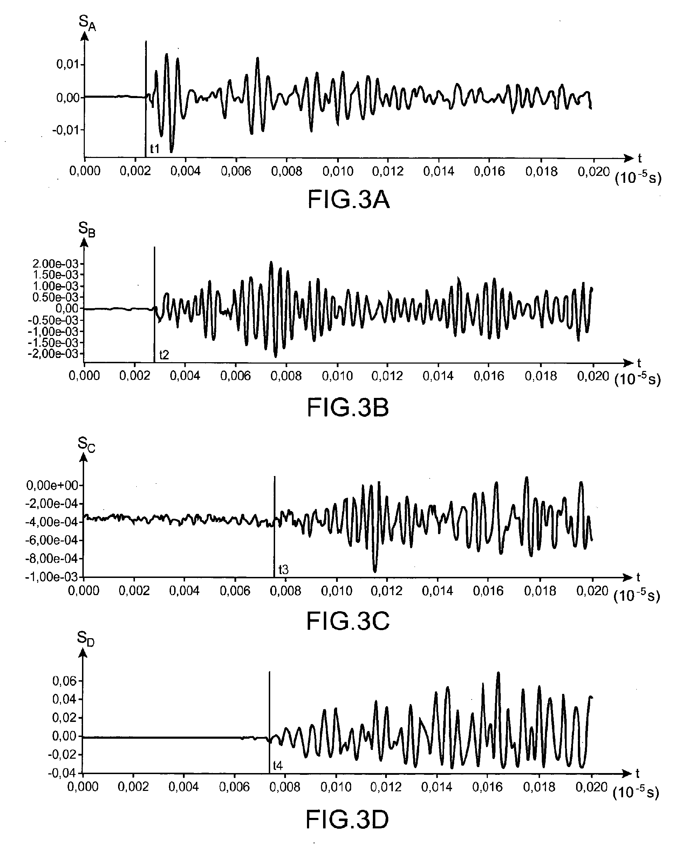

Les figures 3A-3D représentent, à titre d'exemple, des signaux de mesure $S_A$-$S_D$ délivrés par les chaînes de mesure du dispositif de l'invention qui sont associées aux détecteurs respectifs D1-D4. Sur les figures 3A-3D, les instants t1-t4 représentent ainsi les différents instants où une même décharge partielle est détectée par les détecteurs respectifs D1-D4.

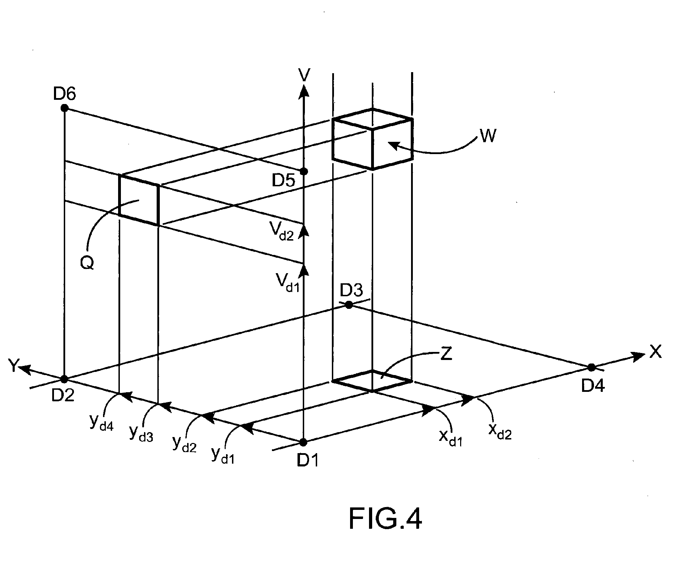

La figure 4 représente un perfectionnement du dispositif qui met en oeuvre le procédé de l'invention. Selon ce perfectionnement, le dispositif de l'invention comprend six chaînes de mesure. Outre les quatre chaînes de mesure précédentes, deux chaînes de mesures supplémentaires, sensiblement identiques aux quatre chaînes de mesure précédentes, sont associés à deux détecteurs UHF supplémentaires D5 et D6. Comme cela a déjà été mentionné ci-dessus, chaque chaîne de mesure comprend un détecteur haute fréquence, par exemple un câble coaxial long, un amplificateur et par exemple un câble coaxial court. Pour des raisons de commodité, seuls les détecteurs D1-D6 sont représentés sur la figure 4.

Les deux détecteurs supplémentaires D5 et D6 sont situés à la verticale des détecteurs respectifs D1 et D2, dans un plan parallèle au plan défini par les détecteurs D1-D4. De la même manière que les détecteurs D1-D4 permettent de définir le plan (X, Y), les détecteurs D1, D2, D5, D6 permettent de définir un plan (Y, V) perpendiculaire au plan (X, Y). Les axes X, Y, V définissent ainsi le trièdre direct [X, Y, V]. Les positions des détecteurs D1, D2, D5 et D6 dans le repère (Y, V) sont telles que le détecteur D1 est placé au point (0, 0), le détecteur D2 au point ($Y_2$, 0), le détecteur D5 au point (0, $V_5$) et le détecteur D6 au point ($Y_6$=$Y_2$, $V_6$=$V_5$).

Comme cela a été mentionné précédemment, les détecteurs D1-D4 permettent de définir, dans le repère (X, Y), une zone plane Z à l'intersection des droites d'équations respectives :

$$X_{d1} = (X_3 /2) + ((TOA_{D2} - TOA_{D3})/2) \times c$$

$$X_{d2} = (X_3 /2) - ((TOA_{D4} - TOA_{D1})/2) \times c$$

$$Y_{d1} = (Y_2 /2) + ((TOA_{D1} - TOA_{D2})/2) \times c$$

$$Y_{d2} = (Y_2 /2) - ((TOA_{D3} - TOA_{D4})/2) \times c$$

Selon le perfectionnement de l'invention, les détecteurs D1, D2, D5 et D6 permettent également de définir, dans le repère (Y, V), une zone plane Q à l'intersection des droites d'équations respectives:

$$Y_{d3} = (Y_2/2) + ((TOA_{D5} - TOA_{D6})/2) \times c$$

$$Y_{d4} = (Y_2/2) - ((TOA_{D2} - TOA_{D1})/2) \times c$$

$$V_{d1} = (V_5/2) + ((TOA_{D1} - TOA_{D5})/2) \times c$$

$$V_{d2} = (V_5/2) - ((TOA_{D6} - TOA_{D2})/2) \times c$$

Où :

- $TOA_{D5}$-$TOA_{D6}$ est la différence de temps, corrigée des données de calibration, entre les instants de réception des signaux détectés par les chaînes de mesure associées aux détecteurs respectifs D5 et D6 ;
- $TOA_{D2}$-$TOA_{D1}$ est la différence de temps, corrigée des données de calibration, entre les instants de réception des signaux détectés par les chaînes de mesure associées aux détecteurs respectifs D2 et D1;
- $TOA_{D1}$-$TOA_{D5}$ est la différence de temps, corrigée des données de calibration, entre les instants de réception des signaux détectés par les chaînes de mesure associées aux détecteurs respectifs D1 et D5; et
- $TOA_{D6}$-$TOA_{D2}$ est la différence de temps, corrigée des données de calibration, entre les instants de réception des signaux détectés par les chaînes de mesure associées aux détecteurs respectifs D6 et D2.

Il est alors possible de définir, dans le trièdre direct [X, Y, V], un volume W dont la projection sur le plan (X, Y) est la surface Z et dont la projection sur le plan (Y, V) est la surface Q. Le volume W localise alors la source de décharge partielle.

**Revendications**

1. Procédé de localisation d'une zone d'émission (Z) de décharge partielle, le procédé comprenant :

   - une étape de calibration de quatre chaînes de mesure sensiblement identiques comprenant, chacune, un détecteur VHF et/ou UHF (D1-D4), l'étape de calibration délivrant, pour chaque chaîne de mesure, une donnée de calibration ($d_{cal}$) associée à la chaîne de mesure,
   - une étape de mesure de signaux de décharge partielle à l'aide des quatre chaînes de mesure, les quatre détecteurs VHF et/ou UHF étant positionnés dans un plan (X, Y) où un détecteur D1 est placé au point (0,0), un détecteur D2 au point (0, $Y_2$), un détecteur D3 au point ($X_3$, $Y_2$) et un détecteur D4 au point (0, $X_3$),
   - une étape de calcul, corrigée des données de calibration, d'une différence de temps $TOA_{D2}$-$TOA_{D3}$ entre les instants de réception des signaux mesurés par les chaînes de mesure associées aux détecteurs respectifs D2 et D3 ;
   - une étape de calcul, corrigée des données de calibration, d'une différence de temps $TOA_{D4}$-$TOA_{D1}$ entre les instants de réception des signaux mesurés par les chaînes de mesure associées aux détecteurs respectifs D4 et D1;
   - une étape de calcul, corrigée des données de calibration, d'une différence de temps $TOA_{D1}$-$TOA_{D2}$ entre les instants de réception des signaux mesurés par les chaînes de mesure associées aux détecteurs respectifs D1 et D2 ;
   - une étape de calcul, corrigée des données de calibration, d'une différence de temps $TOA_{D3}$-$TOA_{D4}$ entre les instants de réception des signaux mesurés par les chaînes de mesure associées aux détecteurs respectifs D3 et D4 ; et

**caractérisé en ce que** le procédé comprend

- une étape de détermination de la zone d'émission à l'intersection des droites $X_{d1}$, $X_{d2}$, $Y_{d1}$ et $Y_{d2}$ définies, dans le repère (X, Y), par les équations ci-dessous:

$$X_{d1} = (X_3/2) + ((TOA_{D2} - TOA_{D3})/2) \times c$$

$$X_{d2} = (X_3/2) - ((TOA_{D4} - TOA_{D1})/2) \times c$$

$$Y_{d1} = (Y_2/2) + ((TOA_{D1} - TOA_{D2})/2) \times c$$

$$Y_{d2} = (Y_2/2) - ((TOA_{D3} - TOA_{D4})/2) \times c$$

où c est la vitesse de la lumière.

2. Procédé selon la revendication 1 qui comprend, en outre :

- lors de l'étape de calibration, une étape de calibration supplémentaire de deux chaînes de mesure supplémentaires sensiblement identiques aux quatre chaînes de mesure, l'étape de calibration supplémentaire délivrant, pour chaque chaîne de mesure supplémentaire, une donnée de calibration supplémentaire ($d_{cal}$) associée à la chaîne de mesure,
- deux étapes de mesure supplémentaires de signaux de décharge partielle à l'aide des deux chaines de mesure supplémentaires, les deux détecteurs supplémentaires D5 et D6 des deux chaînes de mesure supplémentaires étant positionnés, dans un plan parallèle au plan (X, Y), à la verticale des détecteurs respectifs D1 et D2,
- une étape de calcul supplémentaire, corrigée des données de calibration supplémentaires, d'une différence de temps $TOA_{D5} - TOA_{D6}$ entre les instants de réception des signaux mesurés par les chaînes de mesure associées aux détecteurs respectifs D5 et D6 ;
- une étape de calcul supplémentaire, corrigée des données de calibration supplémentaires, d'une différence de temps $TOA_{D1} - TOA_{D5}$ entre les instants de réception des signaux mesurés par les chaînes de mesure associées aux détecteurs respectifs D1 et D5; et
- une étape de calcul supplémentaire, corrigée des données de calibration supplémentaires, d'une différence de temps $TOA_{D6} - TOA_{D2}$ entre les instants de réception des signaux mesurés par les chaînes de mesure associées aux détecteurs respectifs D6 et D2, et
- une étape de détermination d'une zone d'émission supplémentaire (Q) de décharge partielle à l'intersection des droites définies par les équations :

$$Y_{d3} = (Y_6/2) + ((TOA_{D5} - TOA_{D6})/2) \times c$$

$$Y_{d4} = (Y_2/2) - ((TOA_{D2} - TOA_{D1})/2) \times c$$

$$V_{d1} = (V_5/2) + ((TOA_{D1} - TOA_{D5})/2) \times c$$

$$V_{d2} = (V_6/2) - ((TOA_{D6} - TOA_{D2})/2) \times c$$

Où $Y_6$ et $V_6$ sont, respectivement, la position du détecteur D6 dans un repère $(Y, V)$ perpendiculaire au repère $(X, Y)$, les axes X, Y, V définissant un trièdre direct $[X, Y, V]$, et $V_5$ étant la position du détecteur $D_5$ dans le repère $(Y, V)$, $Y_6$ étant égal à $Y_2$ et $V_5$ étant à $V_6$.

3. Procédé selon la revendication 2 dans lequel, dès lors que la zone d'émission de décharge partielle et la zone d'émission de décharge partielle supplémentaire sont déterminées simultanément, il est vérifié s'il existe un volume de l'espace $(W)$ dont la projection sur le plan $(X, Y)$ est définie par la zone d'émission et dont la projection sur le plan $(Y, V)$ est définie par la zone d'émission supplémentaire et, si ce volume existe, celui-ci est déterminé comme étant la zone de décharge partielle.

4. Dispositif de localisation de zone d'émission $(Z, Q)$ de décharge partielle, le dispositif comprenant quatre chaînes de mesure sensiblement identiques comprenant, chacune, un détecteur VHF et/ou UHF (D1-D4), les quatre détecteurs VHF et/ou UHF étant positionnés aux quatre sommets d'un carré ou d'un rectangle dessiné dans un plan de référence $(X, Y)$ et un calculateur $(C)$
**caractérisé en ce que**
le calculateur comprend des moyens aptes à mettre en oeuvre le procédé de la revendication 1, sur la base de mesures délivrées par les quatre chaînes de mesure.

5. Dispositif selon la revendication 4 qui comprend, en outre, deux chaînes de mesure supplémentaires sensiblement identiques aux quatre chaînes de mesure, les deux détecteurs supplémentaires D5 et D6 des deux chaînes de mesure supplémentaires étant positionnés dans un plan parallèle au plan $(X, Y)$, à la verticale des détecteurs respectifs D1 et D2, le calculateur comprenant des moyens supplémentaires pour mettre en oeuvre le procédé de la revendication 2, sur la base des mesures délivrées par les deux chaînes de mesure supplémentaires.

**Patentansprüche**

1. Verfahren zur Ortung eines Teilentladungs-Übertragungsbereichs $(Z)$, wobei das Verfahren umfasst:

- einen Schritt der Kalibrierung von vier im Wesentlichen identischen Messketten, die jeweils einen VHF- und/oder UHF-Sensor (D1 - D4) aufweisen, wobei der Schritt der Kalibrierung für jede Messkette eine Kalibrierungs-Datenangabe $(d_{cal})$ liefert, die der Messkette zugeordnet ist,
- einen Schritt des Messens von Teilentladungs-Signalen mit Hilfe der vier Messketten, wobei die vier VHF- und/oder UHF-Sensoren in einer Ebene $(X, Y)$ angeordnet sind, wo ein Sensor D1 am Punkt $(0, 0)$, ein Sensor D2 am Punkt $(0, Y_2)$ und ein Sensor D3 am Punkt $(X_3, Y_2)$ und ein Sensor D4 am Punkt $(0, X_3)$ liegt,
- einen Schritt der um die Kalibrierungsdaten korrigierten Berechnung einer Zeitdifferenz $TOA_{D2} - TOA_{D3}$ zwischen den Zeitpunkten des Empfangs der Messsignale, die von den Messketten gemessen wurden, denen die jeweiligen Sensoren D2 und D3 zugeordnet sind,
- einen Schritt der um die Kalibrierungsdaten korrigierten Berechnung einer Zeitdifferenz $TOA_{D4} - TOA_{D1}$ zwischen den Zeitpunkten des Empfangs der Messsignale, die von den Messketten gemessen wurden, denen die jeweiligen Sensoren D4 und D1 zugeordnet sind;
- einen Schritt der um die Kalibrierungsdaten korrigierten Berechnung einer Zeitdifferenz $TOA_{D1} - TOA_{D2}$ zwischen den Zeitpunkten des Empfangs der Messsignale, die von den Messketten gemessen wurden, denen die jeweiligen Sensoren D1 und D2 zugeordnet sind;
- einen Schritt der um die Kalibrierungsdaten korrigierten Berechnung einer Zeitdifferenz $TOA_{D3} - TOA_{D4}$ zwischen den Zeitpunkten des Empfangs der Messsignale, die von den Messketten gemessen wurden, denen die jeweiligen Sensoren D3 und D4 zugeordnet sind;

**dadurch gekennzeichnet, dass** das Verfahren umfasst:

- einen Schritt des Bestimmens des Übertragungsbereichs am Schnittpunkt der Geraden $X_{d1}$, $X_{d2}$, $Y_{d1}$ und $Y_{d2}$, die am Bezugspunkt $(X, Y)$ durch nachfolgende Gleichungen definiert sind:

$$X_{d1} = (X_3 / 2) + ( (TOA_{D2} - TOA_{D3}) / 2) \times c$$

$$X_{d2} = (X_3 / 2) - ( (TOA_{D4} - TOA_{D1}) / 2) \times c$$

$$Y_{d1} = (Y_2 / 2) + ( (TOA_{D1} - TOA_{D2}) / 2) \times c$$

$$Y_{d2} = (Y_2 / 2) - ( (TOA_{D3} - TOA_{D4}) / 2) \times c$$

worin c die Lichtgeschwindigkeit ist.

2. Verfahren nach Anspruch 1, das ferner umfasst:

- beim Kalibrierungsschritt einen Schritt der zusätzlichen Kalibrierung von zwei zusätzlichen Messketten, die im Wesentlichen identisch zu den vier Messketten sind, wobei der zusätzliche Kalibrierungsschritt für jede zusätzliche Messkette eine zusätzlichen Kalibrierungs-Datenangabe ($d_{cal}$) liefert, die der Messkette zugeordnet ist,
- zwei zusätzliche Messschritte zum Messen von Teilentladungssignalen mit Hilfe der beiden zusätzlichen Messketten, wobei die beiden zusätzlichen Sensoren D5 und D6 der beiden zusätzlichen Messketten in einer Ebene parallel zur Ebene (X, Y) in der Senkrechten der jeweiligen Sensoren D1 und D2 angeordnet sind,
- einen Schritt der um die zusätzlichen Kalibrierungsdaten korrigierten Berechnung einer Zeitdifferenz $TOA_{D5}$ - $TOA_{D6}$ zwischen den Zeitpunkten des Empfangs der Messsignale, die von den Messketten gemessen wurden, denen die jeweiligen Sensoren D5 und D6 zugeordnet sind;
- einen zusätzlichen Schritt der um die zusätzlichen Kalibrierungsdaten korrigierten Berechnung einer Zeitdifferenz $TOA_{D1}$ - $TOA_{D5}$ zwischen den Zeitpunkten des Empfangs der Messsignale, die von den Messketten gemessen wurden, denen die jeweiligen Sensoren D1 und D5 zugeordnet sind;
- einen zusätzlichen Schritt der um die zusätzlichen Kalibrierungsdaten korrigierten Berechnung einer Zeitdifferenz $TOA_{D6}$ - $TOA_{D2}$ zwischen den Zeitpunkten des Empfangs der Messsignale, die von den Messketten gemessen wurden, denen die jeweiligen Sensoren D6 und D2 zugeordnet sind, und
- einen Schritt des Bestimmens eines zusätzlichen Teilentladungs-Übertragungsbereichs (Q) am Schnittpunkt der Geraden, die durch nachfolgende Gleichungen definiert sind:

$$Y_{d3} = (Y_6 / 2) + ( (TOA_{D5} - TOA_{D6}) / 2) \times c$$

$$Y_{d4} = (Y_2 / 2) - ( (TOA_{D2} - TOA_{D1}) / 2) \times c$$

$$V_{d1} = (V_5 / 2) + ( (TOA_{D1} - TOA_{D5}) / 2) \times c$$

$$V_{d2} = (V_6 / 2) - ( (TOA_{D6} - TOA_{D2}) / 2) \times c$$

wo $Y_6$ und $V_6$ jeweils die Position des Sensors D6 an einem Bezugspunkt (Y, V) senkrecht zum Bezugspunkt (X, Y) sind, wobei die Achsen X, Y, V ein rechtshändiges Dreibein (X, Y, V) definieren, und $V_5$ die Position des Sensors D5 am Bezugspunkt (Y, V) ist, wobei $Y_6$ gleich $Y_2$ und $V_5$ gleich $V_6$ ist.

3. Verfahren nach Anspruch 2, wobei dann, wenn der Teilentladungs-Übertragungsbereich und der zusätzliche Teilentladungs-Übertragungsbereich gleichzeitig bestimmt werden, überprüft wird, ob ein Raumvolumen (W) besteht, dessen Projektion auf die Ebene (X, Y) von dem Übertragungsbereich definiert wird und dessen Projektion auf die Ebene (Y, V) von dem zusätzlichen Übertragungsbereich definiert wird, und, falls dieses Raumvolumen besteht, dieses als der Teilentladungsbereich bestimmt wird.

4. Vorrichtung zur Ortung eines Teilentladungs-Übertragungsbereichs (Z, Q), wobei die Vorrichtung vier im Wesentlichen identische Messketten enthält, die jeweils einen VHF- und/oder UHF-Sensor (D1 - D4) aufweisen, wobei die vier VHF- und/oder UHF-Sensoren (D1 - D4) an den vier Ecken eines Quadrats bzw. Rechtecks angeordnet sind, das in eine Bezugsebene (X, Y) eingezeichnet ist, sowie einen Rechner (C),
**dadurch gekennzeichnet, dass**
der Rechner Mittel enthält, die dazu geeignet sind, das Verfahren nach Anspruch 1 auf Grundlage von Messungen durchzuführen, die von den vier Messketten erbracht wurden.

5. Vorrichtung nach Anspruch 4, die ferner zwei zusätzliche Messketten aufweist, die im Wesentlichen identisch zu den vier Messketten sind, wobei die beiden zusätzlichen Sensoren D5 und D6 der beiden zusätzlichen Messketten in einer Ebene parallel zur Ebene (X, Y) in der Senkrechten der jeweiligen Sensoren D1 und D2 angeordnet sind, wobei der Rechner zusätzliche Mittel aufweist, um das Verfahren nach Anspruch 2 auf Grundlage der Messungen durchzuführen, die von den beiden zusätzlichen Messketten erbracht wurden.

**Claims**

1. A method of locating a partial discharge emission zone (Z), the method comprising:

a step of calibrating four substantially identical measurement channels, each including a very high frequency (VHF) detector and/or an ultra high frequency (UHF) detector (D1-D4), the step of calibrating providing, for each measurement channel, a calibration data ($d_{cal}$) associated with the measurement channel;
• a step of measuring partial discharge signals by means of the four measurement channels, the four VHF and/or UHF detectors being positioned in an (X, Y) plane, a detector D1 is placed at point (0, 0), a detector D2 at point ($0, Y_2$), a detector D3 at point ($X_3, Y_2$), and a detector D4 at point ($0, X_3$) ;
• a step of calculating a time difference $TOA_{D2}$-$TOA_{D3}$ between the reception times of the signals measured by the measurement channels associated with the detectors D2 and D3, respectively, said step of calculating being corrected using the calibration data;
• a step of calculating a time difference $TOA_{D4}$-$TOA_{D1}$ between the reception times of the signals measured by the measurement channels associated with the detectors D4 and D1, respectively, said step of calculating being corrected using the calibration data;
• a step of calculating a time difference $TOA_{D1}$-$TOA_{D2}$ between the reception times of the signals measured by the measurement channels associated with the detectors D1 and D2, respectively, said step of calculating being corrected using the calibration data;
• a step of calculating a time difference $TOA_{D3}$-$TOA_{D4}$ between the reception times of the signals detected by the measurement channels associated with the detectors D3 and D4, respectively, said step of calculating being corrected using the calibration data; and **characterized in that** the method comprises:
• a step of determining the partial discharge emission zone at the intersection of the straight lines $X_{d1}$, $X_{d2}$, $Y_{d1}$, and $Y_{d2}$ defined in the (X, Y) frame of reference by the following equations:

$$X_{d1} = (X_3/2) + ((TOA_{D2} - TOA_{D3})/2) \times c$$

$$X_{d2} = (X_3/2) - ((TOA_{D4} - TOA_{D1})/2) \times c$$

$$Y_{d1} = (Y_2/2) + ((TOA_{D1} - TOA_{D2})/2) \times c$$

$$Y_{d2} = (Y_2/2) - ((TOA_{D3} - TOA_{D4})/2) \times c$$

where c is the speed of light.

2. A method according to claim 1 that further includes:

• during the calibration step, an additional step of calibrating two additional measurement channels that are substantially identical to the four measurement channels, the additional step of calibrating providing, for each additional measurement channel, an additional calibration data ($d_{cal}$) associated with the additional measurement channel;
• two additional steps of measuring partial discharge signals by means of the two additional measurement channels, the two additional detectors D5 and D6 of the two additional measurement channels being positioned in a plane that is parallel to the (X, Y) plane, vertically offset relative to the detectors D1 and D2, respectively;
• a step of calculating a time difference $TOA_{D5}$-$TOA_{D6}$ between the reception times of the signals measured by the measurement channels associated with the detectors D5 and D6, respectively, said step of calculating being corrected using the additional calibration data;
• an additional step of calculating a time difference $TOA_{D1}$-$TOA_{D5}$ between the reception times of the signals measured by the measurement channels associated with the detectors D1 and D5, respectively, said step of calculating being corrected using the additional calibration data;
• a step of calculating a time difference $TOA_{D6}$-$TOA_{D2}$ between the reception times of the signals measured by the measurement channels associated with the detectors D6 and D2, respectively, said step of calculating being corrected using the additional calibration data; and
• a step of determining an additional partial discharge emission zone (Q) at the intersection of the straight lines defined in the equations :

$$Y_{d3} = (Y_6/2) + ((TOA_{D5} - TOA_{D6})/2) \times c$$

$$Y_{d4} = (Y_2/2) - ((TOA_{D2} - TOA_{D1})/2) \times c$$

$$V_{d1} = (V_5/2) + ((TOA_{D1} - TOA_{D5})/2) \times c$$

$$V_{d2} = (V_6/2) - ((TOA_{D6} - TOA_{D2})/2) \times c$$

Where $Y_6$ and $V_6$ are, respectively, the position of the detector D6 in a (Y, V) frame of reference that is perpendicular to the (X, Y) frame of reference, the axes X, Y, V defining a right-handed system of axes [X, Y, V], and $V_5$ being the position of the detector $D_5$ in the (Y, V) frame of reference.

3. A method according to claim 2, wherein, whenever the partial discharge emission zone and the additional partial discharge zone are simultaneously determined, it is verified whether or not there exists a three-dimensional volume (W), said volume having on the (X, Y) plane a projection defined by the emission zone and having a projection on the (Y, V) plane defined by the additional emission zone and, if said volume exists it is determined as being the partial discharge zone.

4. A device for locating a partial discharge emission zone (Z, Q), the device comprising four substantially identical measurement channels, each including a VHF and/or an UHF detector (D1-D4), the four VHF and/or UHF detectors being positioned at the four vertices of a square or rectangle outlined in the plane referenced (X, Y) and a computer (C) **characterized in that** the computer comprises means to implement the method of claim 1 on the basis of measurements delivered by the four measurement chains.

5. A device according to claim 4, further including two additional measurement channels that are substantially identical to the four measurement channels, the two additional detectors D5 and D6 of the two additional measurement channels being positioned in a plane that is parallel to the (X, Y) plane, vertically offset relative to the detectors D1 and D2, respectively, the two additional measurement channels being connected to the computer (C).

FIG.1

FIG.2

FIG.3A

FIG.3B

FIG.3C

FIG.3D

FIG.4

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 0955550 A1

**Littérature non-brevet citée dans la description**

- RF-Based Partial Discharge Early Waming System for Air-Insulated Substations. **PORTUGUES I E et al.** IEEE TRANSACTIONS ON POWER DELIVERY. IEEE SERVICE CENTER, 01 Janvier 2009, vol. 24, 20-29
- Radiometric Location of Partial Discharge Sources on Energized High-Voltage Plant. **GLOVER I A et al.** IEEE TRANSACTIONS ON POWER DELIVERY. IEEE SERVICE CENTER, 01 Juillet 2005, vol. 20, 2264-2272
- Triangulation and 3D location estimation of RFI and Partial Discharge sources within a 400kV substation. **STEWART B G et al.** ELECTRICAL INSULATION CONFERENCE, 2009. EIC 2009. IEEE, 31 Mai 2009, 164-168